Europäisches Patentamt

European Patent Office

Office européen des brevets

(19)

(11) Veröffentlichungsnummer: **0 236 887 B1**

(12) # EUROPÄISCHE PATENTSCHRIFT

(45) Veröffentlichungstag der Patentschrift: **13.11.91**

(51) Int. Cl.⁵: **H03L 7/08, H03B 5/18**

(21) Anmeldenummer: **87102884.1**

(22) Anmeldetag: **28.02.87**

(54) **Mikrowellen-Oszillator mit Stabilisierung durch einen dielektrischen Resanator.**

(30) Priorität: **14.03.86 DE 3608471**

(43) Veröffentlichungstag der Anmeldung:
**16.09.87 Patentblatt 87/38**

(45) Bekanntmachung des Hinweises auf die
Patenterteilung:
**13.11.91 Patentblatt 91/46**

(84) Benannte Vertragsstaaten:
**DE GB NL**

(56) Entgegenhaltungen:

**IEEE MTT-S INTERNATIONAL MICROWAVE
SYMPOSIUM DIGEST 1979, Seiten 197-199,
IEEE, New York, US; T. SAITO et al.: "A 6 GHz
highly stabilized GaAs FET oscillator using a
dielectric resonator"**

**CONFERENCE PROCEEDINGS OF THE 15TH
EUROPEAN MICROWAVE CONFERENCE, Paris, 9.-13. September 1985, Seiten 407-412; K.
WADA et al.: "Wideband tunable DR VCO"**

**REVIEW OF THE ELECTRICAL COMMUNICA-
TION LABORATORIES, Band 30, Nr. 2, März
1982, Seiten 326-334, Tokyo, JP; S. YUKI et
al.: "Frequency synthesizer for new mobile**

radio unit"

(73) Patentinhaber: **Licentia Patent-
Verwaltungs-GmbH
Theodor-Stern-Kai 1
W-6000 Frankfurt/Main 70(DE)**

(72) Erfinder: **Wiesbeck, Werner, Prof. Dr. Dr.-Ing.
Ettlinger Strasse 36
W-7538 Ellmendingen(DE)**
Erfinder: **Feldle, Heinz-Peter, Dipl.-Ing.
Feuerbachstrasse 7
W-6704 Mutterstadt(DE)**

**Beschreibung**

Die Erfindung bezieht sich auf einen Mikrowellen-Oszillator nach dem Oberbegriff des Anspruchs 1. Ein solcher mit einem dielektrischen Resonator stabilisierter Mikrowellen-Oszillator ist aus G. Begemann, J. Göhler, "Frequenzstabilisierung von Mikrostrip-FET-Oszillatoren mit dielektrischen Resonatoren", NTG-Fachberichte 1981, "Rundfunk-Satellitensysteme", Saarbrücken, 19-21.10.1982, Seite 252 bis 259 bekannt.

Dielektrische Resonatoren sind Körper aus einem Dielektrikum mit hoher Dielektrizitätszahl, d.h. aus einer dielektrischen Keramik. Aufgrund der hohen Differenz zwischen der Dielektrizitätszahl des Resonators und derjenigen seiner Umgebung können sich bei entsprechender Anregung im Resonator stehende elektromagnetische Wellen ausbilden. Die elektrischen und magnetischen Felder dielektrischer Resonatoren haben ähnliche Konfigurationen wie diejenigen von Hohlraumresonatoren. Innerhalb des dielektrischen Resonators sind die Felder hochkonzentriert. Über die schwächeren äußeren magnetischen Felder können Resonatoren untereinander oder an Leitungsstücke gekoppelt werden. Durch Beeinflussung der äußeren magnetischen oder elektrischen Felder können dielektrische Resonatoren auch bezüglich ihrer Resonanzfrequenz abgestimmt werden.

Zur Abstimmung der dielektrischen Resonatoren sind metallische Abstimmittel in Form von Stiften oder Platten geeignet, die an einem Bügel oder an einem Gehäusedeckel befestigt sind und bezüglich ihres Abstandes von der Oberfläche, und zwar der Oberseite des dielektrischen Resonators z.B. mit einer Stellschraube veränderbar sind. Diese Abstimmittel berühren also den Resonator nicht, sondern werden lediglich in das den Resonator umgebende Feld (Streufeld) eingetaucht.

Die Abstimmung mit Hilfe der bekannten Abstimmittel macht es erforderlich, die Abstimmittel sehr nahe (einige Zehntel Millimeter bis einige Millimeter) an den Resonator heranzubringen und dort während des Betriebs mit hoher Genauigkeit zu halten. Dadurch ist ein hoher mechanischer Aufwand notwendig zur Fixierung der Abstimmittel in der Nähe des Resonators, wobei die Schock- und Vibrationsempfindlichkeit bzw. der Temperaturgang der einzelnen Teile zu berücksichtigen ist.

Zwar kann der Temperaturgang durch geeignete Materialwahl und Dimensionierung der Abstimmittel und des Gehäuses in gewissen Grenzen ausgeglichen werden, jedoch reicht diese Möglichkeit nicht in allen Anwendungsfällen aus, um einen den Anforderungen entsprechenden Oszillator herzustellen. Außerdem ist eine aufwendige Selektion von dielektrischen Resonatoren erforderlich, die den Temperaturgang anderer Oszillator-Elemente kompensieren. Eine solche Auswahl und die mechanische Abstimmung erschweren eine Automatisierung der Herstellung.

Aus T. Otobe, Y. Komatsu, Y. Murakami, "A low-drift oscillator stabilized by a highly sensitive discriminator", 13th European Microwave Conference Proceedings, Nürnberg, 1983, Seite 319 bis 324 ist ein Mikrowellen-Oszillator mit einem dielektrischen Resonator bekannt, der mit Hilfe eines mikroprozessorgesteuerten Diskriminators temperaturstabilisiert ist. Die dabei vorgesehene Anordnung zur Temperaturstabilisierung ist sehr aufwendig, da außer einem Mikroprozessor-System ein Wärmefühler und ein als analog arbeitender Frequenzzähler benutzter Diskriminator erforderlich sind. Die Temperaturstabilisierung wird über eine elektrische Ansteuerung von Dual-Gate-FET's erreicht, wodurch eine Beschränkung auf niedrige Frequenzen gegeben ist und Frequenzänderungen nur in engen Grenzen möglich sind.

Der vorliegenden Erfindung liegt die Aufgabe zugrunde, einen Mikrowellen-Oszillator mit Temperaturstabilisierung anzugeben, bei dem die Nachteile der bekannten Oszillatoren vermieden sind.

Diese Aufgabe wird bei einem Mikrowellen-Oszillator nach dem Oberbegriff des Anspruchs 1 durch dessen kennzeichnende Merkmale gelöst. Vorteilhafte Ausgestaltungen sind in Unteransprüchen angegeben.

Der erfindungsgemäße Mikrowellen-Oszillator weist nicht nur eine besonders hohe Frequenzstabilität auf, sondern ist auch kostengünstig realisierbar. Je nach der Art des verwendeten elektromagnetischen Wandlers ist entweder eine Grob-Abstimmung mit Hilfe einer Abstimm-Schraube oder gar keine mechanische Abstimmung erforderlich.

Die mit der Erfindung vorgeschlagene Verwendung einer Phasenregelschleife (PLL-Schaltung) ist an sich bekannt für sehr hoch stabilisierte Oszillatoren und Synthesizer, also Oszillatoren die in Schritten abgestimmt werden. In solchen bekannten Oszillatoren sind jedoch keine dielektrischen Resonatoren eingesetzt, sondern andere Bauelemente, üblicherweise steuerbare Kapazitäten oder steuerbare Induktivitäten. Obwohl dielektrische Resonatoren wegen ihrer geringen Abmessungen und ihrer hohen Güte im Frequenzbereich von etwa 2 bis 50GHz vorteilhaft eingesetzt werden können, wurden sie nicht in Verbindung mit einer Phasenregelschleife benutzt, weil sie als nichtsteuerbar, frequenzbestimmende Bauelemente angesehen wurden. Da jedoch die Resonanzfrequenz von dielektrischen Resonatoren über die elektromagnetische Feldkonfiguration beeinflußt werden kann, ist es möglich, einen dielektrischen Resonator als frequenzbestimmendes Element mit variabler Frequenz zu verwenden. Dazu muß nach dem erfindungsgemäßen Vorschlag die sonst übliche Abstimm-Schraube durch ein elektrisch ansteuerbares Element ergänzt oder ersetzt werden, das den Abstand von Abstimmitteln zum dielektrischen Resonator in Abhängigkeit von einem elektrischen Signal verändert. Dies wird mit einem elektromagnetischen Wandler, wie z.B. einem Piezo-Element, einem magneto-striktiven Bauelement oder einer Tauchspule erreicht. Die vorgeschlagene technische Lösung ist bei allen bekannten Oszillator-Varianten anwendbar. Darüberhinaus läßt sich das vorgeschlagene Verfahren zur Abstimmung von dielektrischen Resonatoren auch für dielektrischen Resonatoren in Filtern vorteilhaft anwenden. Schließlich kann die PLL-Abstimmung dielektrischer Resonatoren sowohl für Single-Gate- als auch Dual-Gate-FET's benutzt werden.

Die Erfindung wird nachstehend anhand von Ausführungs-beispielen und der Zeichnung näher beschrieben.

Es zeigen:

Fig. 1 ein Schaltungs-Schema eines Mikrowellen-Oszillators mit dielektrischem Resonator und einer Phasenregelschleife,

Fig. 2 ein Ausführungsbeispiel für die Anordnung eines Piezo-Elementes als steuerbares Abstimmungselement in einem Mikrowellen-Oszillator gemäß Fig. 1.

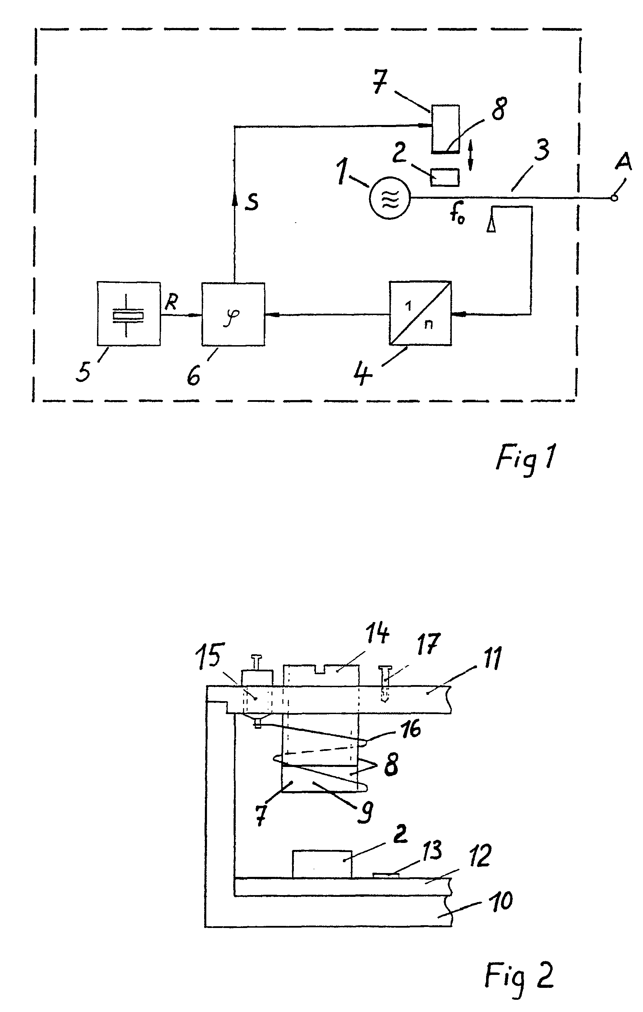

Fig. 1 zeigt ein Schaltungs-Schema für einen Mikrowellen-Oszillator 1, dessen Ausgangssignal eine Frequenz $f_0$ hat, die über den nachstehend beschriebenen Phasenregelkreis mit einem dielektrischen Resonator 2 stabilisiert ist. Von einem Ausgangssignal A des Oszillators 1 wird ein Teil-Signal über einen Richtkoppler 3 ausgekoppelt und in einem Frequenzteiler 4 so aufbereitet, daß es in einem Phasenvergleicher 6 mit einem Referenzsignal R aus einem z.B. quarzgesteuerten Referenzoszillator 5 verglichen werden kann. Der Phasenvergleicher 6 bildet ein Fehlersignal und setzt es um in ein Steuersignal S für einen elektromechanischen Wandler 7. Der elektromechanische Wandler 7 verändert den Abstand eines Abstimmungselementes 8 vom dielektrischen Resonator 2. Abstimmungselement 8 kann z.B. der Wandler 7 selbst sein.

Der Wandler 7 mit dem Abstimmelement 8 wirkt also in dem Phasenregelkreis als Stellglied, durch das das elektromagnetische Feld des dielektrischen Resonators 2 so beeinflußt wird, daß das Fehlersignal im Phasenvergleicher 6 zu Null wird. Die erreichbare kurz- und langfristige Frequenzstabilität ist praktisch nur von der Stabilität des Referenz-Oszillators abhängig.

Als elektromechanischen Wandler 7 kann z.B. eine Tauchspule verwendet werden. Durch Veränderung des Spulenstromes in Abhängigkeit von dem Steuersignal S kann ein Hub - und damit eine Änderung des Abstandes des Abstimmelements 8 vom dielektrischen Resonator 2 - von einigen Millimetern erreicht werden. Damit wird ein größerer Ziehbereich für die Frequenz $f_0$ möglich. Allerdings sind Tauchspulen wegen ihrer Vibrations- und Schockempfindlichkeit nicht für alle Anwendungsfälle geeignet.

Da im allgemeinen zur Stabilisierung der Frequenz $f_0$ ein sehr kleiner mechanischer Hub des Stellgliedes 7, 8 ausreicht, ist auch der Einsatz von Piezo-Elementen oder magnetostriktiven Elementen möglich, die nicht die Erschütterungsempfindlichkeit der Tauchspule aufweisen. Bei Piezo-Elementen wird der reziproke longitudinale oder reziproke transversale piezoelektrische Effekt ausgenutzt, wobei sich das Element durch die elektrische Aufladung der Elektroden verlängert oder verkürzt. Magnetostriktive Elemente aus ferromagnetischen Stoffen ziehen sich zusammen oder dehnen sich in Feldrichtung unter dem Einfluß eines magnetischen Feldes.

Ein Ausführungsbeispiel für die Anordnung eines Piezoelementes 9 als Wandler 7 und Abstimmungselement 8 ist in Fig. 2 dargestellt. Die Fig. 2 zeigt einen Ausschnitt eines Gehäuses 10 mit einem Gehäusedeckel 11. Auf den Boden des Gehäuses ist ein Substrat 12 (z.B. eine Keramikplatte) angeordnet, das eine Streifenleitung 13 eines nicht weiter dargestellten Streifenleitungsoszillators trägt. Neben der Streifenleitung 13 ist in bekannter Weise ein dielektrischer Resonator 2 angeordnet. Oberhalb des dielektrischen Resonators 2 ist im Gehäusedekkel 11 eine Schraube 14 angeordnet zur Grob-Abstimmung des dielektrischen Resonators 2. An dem dem dielektrischen Resonator 2 zugewandten Ende der Schraube 14 ist das Piezo-Element 9 befestigt. Die Zuführung des Steuerstromes für das Piezo-Element 9 erfolgt über ein Durchgangsfilter 15 (mit elektrischer Tiefpaßcharakteristik), eine Drahtverbindung 16 zum Piezo-Element 9 und von dort zurück über die Schraube 14 und einen Masseanschluß 17 am Gehäusedeckel 11.

## Patentansprüche

1. Mikrowellen-Oszillator mit Stabilisierung durch einen dielektrischen Resonator, wobei der dielektrische Resonator durch Beeinflussung seines äußeren magnetischen oder elektrischen Feldes durch ein Abstimmittel abgestimmt ist, dadurch gekennzeichnet, daß zur Abstimmung des dielektrischen Resonators (2) ein elektromechanischer Wandler (7) vorgesehen ist, der den Abstand des Abstimmittels (8) vom dielektrischen Resonator (2) verändert und daß der elektromechanische Wandler (7) Stellglied in einem Phasenregelkreis ist.

2. Mikrowellen-Oszillator nach Anspruch 1, dadurch gekennzeichnet, daß der Phasenregelkreis durch nachstehende Einrichtungen gebildet ist:
 - einen Richtkoppler (3) zur Auskopplung eines Teils eines Ausgangssignals (A) des Mikrowellen-Oszillators (1),
 - einen Frequenzteiler (4), der das ausgekoppelte Signal aufbereitet für einen Phasenvergleich,
 - einen Phasenvergleicher (6), der das aufbereitete Signal aus dem Frequenzteiler (4) vergleicht mit einem Referenzsignal (R) aus einem Referenzoszillator (5) und ein Steuersignal (S) bildet zur Steuerung des elektromechanischen Wandlers (7).

3. Mikrowellen-Oszillator nach Anspruch 1 oder 2, dadurch gekennzeichnet, daß als elektromechanischer Wandler (7) eine Tauchspule vorgesehen ist.

4. Mikrowellen-Oszillator nach Anspruch 1 oder 2, dadurch gekennzeichnet, daß als elektromechanischer Wandler (7) ein Piezo-Element (9) vorgesehen ist.

5. Mikrowellen-Oszillator nach Anspruch 1 oder 2, dadurch gekennzeichnet, daß als elektromechanischer Wandler (7) ein magnetostriktives Element vorgesehen ist.

## Claims

1. Microwave oscillator with stabilising by a dielectric resonator, wherein the dielectric resonator is tuned through influencing of its outer magnetic or dielectric field by a tuning means, characterised thereby that provided for the tuning of the dielectric resonator (2) is an electromechanical converter (7), which changes the spacing of the tuning means (8) from the dielectric resonator (2) and that the electromechanical converter (7) is a setting element in a phase regulating circuit.

2. Microwave oscillator according to claim 1, characterised thereby that the phase regulating circuit is formed by the following devices:
 - a directional coupler (3) for decoupling a part of an output signal (A) of the microwave oscillator (1),
 - a frequency divider (4), which prepares the decoupled signal for a phase comparison,
 - a phase comparator (6), which compares the prepared signal from the frequency divider (4) with a reference signal (R) from a reference oscillator (5) and forms a control signal (S) for the controlling of the electromechanical converter (7).

3. Microwave oscillator according to claim 1 or 2, characterised thereby that a moving coil is provided as electromechanical converter (7).

4. Microwave oscillator according to claim 1 or 2, characterised thereby that a piezoelectric element (9) is provided as electromechanical converter (7).

5. Microwave oscillator according to claim 1 or 2, characterised thereby that a magnetostrictive element is provided as electromechanical converter (7).

## Revendications

1. Oscillateur à micro-ondes avec stabilisation par un résonateur diélectrique, celui-ci étant accordé grâce à l'influence exercée sur son champ électrique ou magnétique extérieur par un moyen d'accord, caractérisé en ce que l'on a prévu, pour l'accord du résonateur diélectrique (2), un transformateur électromécanique (7) modifiant la distance du moyen d'accord (8) par rapport au résonateur diélectrique (2), ce transformateur électromécanique (7) servant de composant de réglage dans un circuit de réglage de la phase.

2. Oscillateur à micro-ondes selon la revendication 1, caractérisé en ce que le circuit de réglage de la phase est constitué par les dispositifs suivants :

 - un coupleur directif (3) pour le découplage d'une partie d'un signal de départ (A) de l'oscillateur à micro-ondes (1),
 - un diviseur de fréquence (4) qui traite le signal découplé en vue d'une comparaison des phases,
 - un indicateur de phase (6) qui compare le signal traité du diviseur de fréquence (4) à un signal de référence (R) d'un oscillateur de référence (5) et qui émet un signal de commande (S) pour la commande du transformateur électromécanique (7).

3. Oscillateur à micro-ondes selon les revendications 1 ou 2, caractérisé en ce que le transformateur électroméanique (7) se présente sous forme de bobine mobile.

4. Oscillateur à micro-ondes selon les revendications 1 ou 2, caractérisé en ce que le transformateur électromécanique (7) se présente sous forme d'élément piézoélectrique (9).

5. Oscillateur à micro-ondes selon les revendications 1 ou 2, caractérisé en ce que le transformateur électromécanique (7) se présente sous forme d'élément magnétostrictif.

Fig 1

Fig 2